**Europäisches Patentamt**

(19) **European Patent Office**

**Office européen des brevets**

(11) Numéro de publication: **0 083 531**
**B1**

(12) # FASCICULE DE BREVET EUROPEEN

(45) Date de publication du fascicule du brevet:
**22.05.85**

(51) Int. Cl.⁴: **H 01 L 47/02**

(21) Numéro de dépôt: **82402367.5**

(22) Date de dépôt: **23.12.82**

(54) **Dispositif unipolaire à transfert d'électrons du type diode gunn.**

(30) Priorité: **31.12.81 FR 8124568**

(43) Date de publication de la demande:
**13.07.83 Bulletin 83/28**

(45) Mention de la délivrance du brevet:
**22.05.85 Bulletin 85/21**

(84) Etats contractants désignés:
**DE GB NL**

(56) Documents cités:
**EP - A - 0 078 726**
**FR - A - 2 293 067**
**GB - A - 1 434 308**

**IBM TECHNICAL DISCLOSURE BULLETIN, vol. 24, no. 7B, décembre 1981, pages 3701-3702, New York, US L.L. CHANG et al.: "Variable-threshold gunn oscillators by quantum states"**

(73) Titulaire: **THOMSON-CSF, 173, Boulevard Haussmann, F-75379 Paris Cedex 08 (FR)**

(72) Inventeur: **Diamand, Félix, THOMSON-CSF SCPI 173, bld Haussmann, F-75379 Paris Cedex 08 (FR)**
Inventeur: **Nuyen, Trong Linh, THOMSON-CSF SCPI 173, bld Haussmann, F-75379 Paris Cedex 08 (FR)**

(74) Mandataire: **Taboureau, James et al, THOMSON-CSF SCPI 173, Bld Haussmann, F-75379 Paris Cedex 08 (FR)**

ACTORUM AG

## Description

L'invention concerne une diode à transfert d'électrons, appelée plus couramment diode Gunn. L'objet de l'invention est d'augmenter la puissance utile de la diode et d'étendre la plage de fonctionnement dans le domaine des hyperfréquences.

Les diodes Gunn sont des composants hyperfréquences de génération ou d'amplification dont le fonctionnement repose sur un mécanisme de résistance négative de volume, inhérent à certains composés de la famille III-V, en particulier GaAs et InP, entre autres.

Le fonctionnement d'une diode Gunn dépend d'une manière critique des conditions aux limites à la cathode. La nature du contact cathodique et la structure de la région contiguë à ce contact ont des répercussions très sensibles sur le mode de fonctionnement du dispositif ainsi que sur les caractéristiques fonctionnelles de celui-ci en rendement électrique, puissance, plage de fréquence, bruit, etc.

Selon l'essentiel du mécanisme de résistance négative d'une diode Gunn, la bande de conduction des composés III-V tels que GaAs ou InP comporte deux vallées, parfois trois, mais on se limitera au modèle plus simple de deux vallées: la vallée principale dans laquelle les électrons sont très mobiles (u > 5000 cm²/V/s pour une concentration de dopage $N_d \sim 10^{15}$ cm$^{-3}$) et la vallée secondaire dans laquelle la mobilité est environ 20 fois plus faible. Le minimum secondaire est situé, dans l'échelle des énergies, à quelques dixièmes d'électrons-volts (0,35 eV pour GaAs, 0,5 eV pour InP) au-dessus du minimum principal. Il en résulte que, si l'on applique un champ électrique à un barreau de GaAs muni de deux contacts ohmiques, la mobilité apparente sera fonction de la valeur de ce champ électrique. Pour un champ faible, les électrons sont presque tous dans la vallée principale et la mobilité moyenne est grande. Si l'on augmente le champ, l'énergie cinétique moyenne des électrons augmente, donc la population de la vallée secondaire augmente au détriment de la vallée principale, d'où une diminution de la mobilité moyenne. Lorsque le champ atteint une valeur dite critique $E_C$ de l'ordre de 3500 V/cm pour GaAs (10000 V/cm pour InP), ce transfert entre vallées devient suffisamment notable pour que la mobilité différentielle soit négative ($\mu = \dfrac{dV}{dE} < 0$). Dans ces conditions, il est possible, si les paramètres physiques sont choisis convenablement (dopage, longueur, etc.), d'obtenir aux bornes du barreau une résistance négative dans un domaine de fréquences plus ou moins étendu englobant la fréquence de transit. C'est ce mécanisme qui est mis en œuvre dans les diodes à transfert d'électrons.

Il est remarquable qu'il s'agit d'un effet de volume, c'est-à-dire associé à un certain type de matériau de composition homogène, par opposition à d'autres effets de résistance négative (diode tunnel, diode à avalanche) qui sont associés à des structures composites beaucoup plus élaborées.

Cependant, malgré la grande simplicité de la structure, l'effet Gunn est un mécanisme très complexe. D'une part, même pour un matériau parfaitement homogène, la densité statique des électrons n'est pas uniforme dans la direction du champ électrique, l'allure particulière de ce profil de densité étant fonction des conditions aux limites à la cathode et de la valeur du champ appliqué. D'autre part, si le champ est supérieur au champ critique $E_C$, une inhomogénéité de charge électronique tend à croître dans le temps. $\sigma_d$ étant la conductivité différentielle, $\varepsilon$ la constante diélectrique du milieu, le taux de croissante $\sigma_d/\varepsilon$ est lié à la relaxation diélectrique, qui correspond à un amortissement négatif puisque $\sigma_d < 0$, tout en se propageant de la cathode vers l'anode à la vitesse moyenne des porteurs. Il s'agit donc d'une instabilité convective dont les caractéristiques dépendent non seulement des propriétés physiques du matériau, mais aussi, d'une manière très critique, des conditions initiales, c'est-à-dire des conditions d'injection à la cathode.

Parmi d'autres solutions connues pour réaliser un contact cathodique qui contrôle les conditions d'injection (contact Schottky, ou mince couche de dopage élevé intercalée dans la couche active de la diode) la société titulaire a révélé, dans la demande de brevet européen EP-A N° 0078726 appartenant à l'état de la technique selon l'article 54(3), une solution qui modifie le rapport de transparence de la cathode, au moyen de zones isolantes amorphisées situées sous la métallisation de cathode, ces zones isolantes ayant la forme de bandes, d'anneaux ou de plots. Ce dispositif du type diode Gunn comprend une couche de transit, supportée par une couche tampon et par un substrat.

L'état de la technique connu de GB-A N° 1434308 décrit un dispositif unipolaire à transfert d'électrons, du type diode Gunn, fonctionnant dans le domaine des hyperfréquences, dont le corps semi-conducteur comprend une couche de contact porteuse d'une première métallisation de prise de contact, cette couche étant constituée en un premier matériau très dopé de polarité n⁺, et une couche de transit constituée du même matériau moins dopé de polarité n, ces deux couches étant supportées par un substrat du même matériau et de même dopage que la couche de contact, le substrat constituant le contact anodique du dispositif et supportant une seconde métallisation de prise de contact, l'injection des électrons depuis la couche de contact vers la couche de transit étant réalisée à travers une double hétérojonction constituée par une couche d'un second matériau non dopé.

L'état de la technique connu de FR-A N° 2293067 décrit un dispositif unipolaire à transfert d'électrons, du type diode Gunn, fonctionnant dans le domaine des hyperfréquences, dont le corps semi-conducteur comprend une couche de transit dopée de polarité n, l'injection des électrons vers la couche de transit étant réalisée par effet tunnel à travers une double hétérojonction constituée par une couche d'un second matériau, non dopé, présentant une barrière tunnel dans la bande de conduction.

La structure de cathode proposée dans EP-A N° 0078726 est une solution différente au même problème, auquel l'invention apporte une solution simple dans son fondement et dans sa réalisation. Elle permet d'atteindre les caractéristiques d'injection convenables. Sa technologie, basée sur l'épitaxie par jets moléculaires par exemple, est particulièrement bien adaptée à des structures exigeant une bonne définition.

On prendra pour l'exposer l'exemple non limtatif d'une diode GaAs/Al$_x$Ga$_{1-x}$As dopée de type n. L'injection de courant est réalisée par effet tunnel à travers une couche mince de Al$_x$Ga$_{1-x}$As non dopée, comprise entre une première couche très mince de GaAs dopée n$^+$, et une deuxième couche de dopage n et d'épaisseur convenable qui constitue la région de transit. Cette région est séparée du substrat n$^+$ par une couche tampon n$^+$. Les deux surfaces libres du côté cathode et du côté anode sont métallisées et des contacts ohmiques sont formés.

De façon plus précise, l'invention consiste en un dispositif unipolaire à transfert d'électrons, du type diode Gunn, fonctionnant dans le domaine des hyperfréquences, dont le corps semi-conducteur comprend une couche de contact porteuse d'une première métallisation de prise de contact, cette couche étant constituée en un premier matériau très dopé de polarité n$^+$, et une couche de transit constituée du même matériau moins dopé de polarité n, ces deux couches étant supportées par une couche tampon et par un substrat du même matériau et de même dopage que la couche de contact, le substrat constituant le contact anodique du dispositif et supportant une seconde métallisation de prise de contact, l'injection des électrons depuis la couche de contact vers la couche de transit étant réalisée par effet tunnel à travers une double hétérojonction constituée par une couche d'un second matériau, non dopé, présentant une barrière tunnel dans la bande de conduction, cette couche non dopée étant intercalée entre la couche de contact et la couche de transit.

L'invention sera mieux comprise par la description d'un exemple de réalisation, faite en s'appuyant sur les figures jointes en annexe qui représentent:

fig. 1: les caractéristiques cathodiques d'un contact de diode à transfert d'électrons, selon l'art connu;

fig. 2: la structure de la région cathodique d'une diode selon l'invention;

fig. 3 et 4: les schémas de bandes de conduction de la structure proposée par l'invention;

fig. 5, 6, 7: les caractéristiques cathodiques d'un contact de diode Gunn selon l'invention.

L'exposé de l'invention sera plus facilement compris par le rappel préliminaire des conditions d'injection des électrons dans les diodes Gunn.

Lorsqu'une diode Gunn est couplée à un circuit pour constituer un oscillateur, plusieurs modes de fonctionnement plus ou moins performants sont possibles, suivant la nature du contact cathodique et les paramètres physiques de la diode. Une amélioration très notable de la puissance HF et du rendement d'un oscillateur a été obtenue, dans le cas du InP, par une conception appropriée de la région cathodique.

On connaît deux classes de contacts cathodiques: les contacts injectants et les contacts limitants.

Le contact injectant apporte un excès de densité électronique par rapport à la densité de donneurs. Le contact ohmique ou la jonction n$^+$n en sont des exemples typiques.

Le contact limitant conduit à un défaut de densité électronique par rapport à la densité de donneurs. Ses caractéristiques sont les suivantes:

a) La densité électronique $n < N_d$ dans toute la couche. Elle croît de la cathode vers l'anode pour tendre vers $N_d$ si la région de transit est assez longue.

b) Il en résulte que le champ E décroît de la cathode vers l'anode.

c) Un contact limitant peut être bloquant, c'est-à-dire qu'il reste limitant pour toute valeur de champ cathodique. Il peut être limitant à bas champ et injectant à haut champ en croisant la caractéristique neutre. Au point de croisement, le champ devient constant dans toute la couche.

d) Un contact limitant évite la formation de couches d'accumulation avec les inconvénients mentionnés précédemment.

e) Le champ étant maximal à la cathode, la zone morte est très étroite, ce qui a permis d'obtenir d'excellentes performances de puissance et rendement dans le cas d'oscillateurs Gunn.

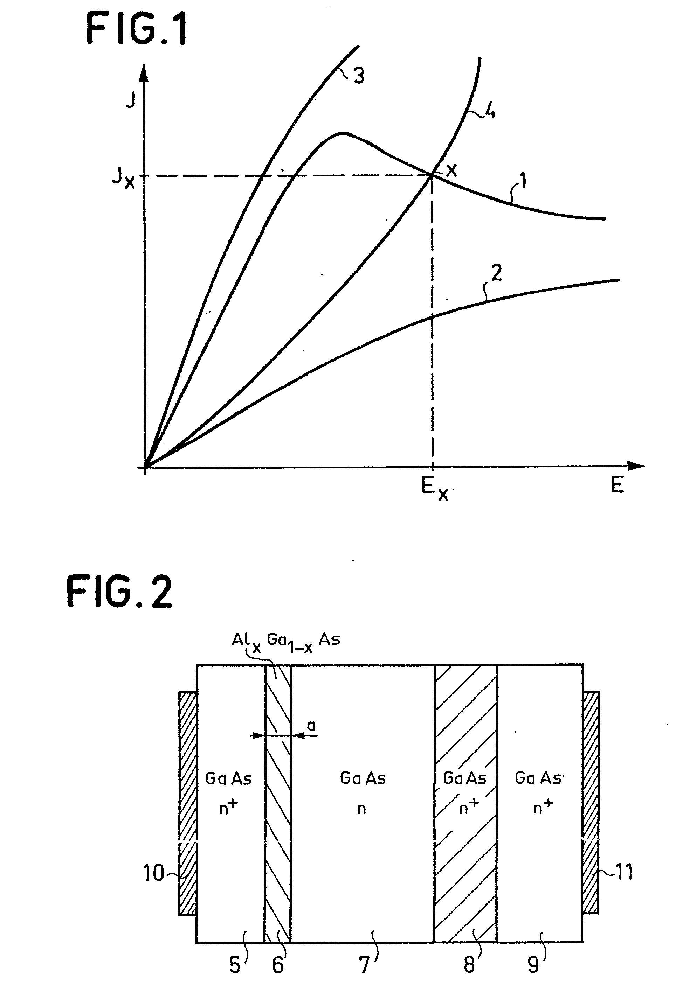

La fig. 1 représente les caractéristiques d'un contact cathodique et donne les différentes courbes de densité de courant J en fonction du champ cathodique E, pour les contacts injectants, et les contacts limitants.

Le champ E étant donné en abscisses, et la densité $J = N_d qv(E)$ en ordonnées, la courbe repérée 1 correspond à une caractéristique neutre. La courbe 2, telle qu'elle ne recoupe pas la courbe 1 de caractéristique neutre pour toute valeur du champ et lui est inférieure, conduit à un contact limitant bloquant. Au contraire, la courbe 3 est d'ordonnée toujours supérieure à la courbe 1, quel que soit le champ: elle correspond à un contact injectant. Enfin, la courbe 4 recoupe la courbe 1 en un point X correspondant à un champ $E_x$: si le champ $E > E_x$ le contact est injectant, et si $E < E_x$ le contact est limitant.

Les propriétés d'une diode Gunn sont améliorées si le contact cathodique est limitant, mais aussi si la zone dite morte devant la cathode est aussi courte que possible.

La zone morte a une épaisseur de l'ordre de grandeur de la distance que doit parcourir un électron depuis la cathode avant d'être suffisamment chauffé par le champ électrique pour que le transfert dans la vallée supérieure se produise. La zone morte constitue une résistance d'accès additionnelle. Elle doit être aussi mince que possible, notamment pour les fréquences les plus élevées où l'extension de la région de transit devient du même ordre de grandeur. Pour réduire la zone morte, le champ électrique au niveau de la cathode doit être aussi grand que possible, ce qui a conduit à expérimenter un contact Schottky à faible barrière ou une cathode composite dont le contact ohmique est suivi d'une structure composée d'une couche peu dopée puis d'une fine couche très dopée, formant une barrière.

Parmi les solutions proposées jusqu'à présent, la cathode Schottky à faible barrière ne semble pas très industrielle en raison d'une reproductibilité médiocre, et la cathode composite a donné d'excellents résultats, mais sa technologie sophistiquée semble peu industrielle.

La fig. 2 représente une vue en coupe d'une diode Gunn selon l'invention. Cette figure est schématisée en vue de mettre en évidence la structure des couches semi-conductrices plutôt que la géométrie réelle de la diode.

Afin de simplifier les explications, l'invention sera décrite en s'appuyant sur le cas du couple de matériaux GaAs/$Al_xGa_{1-x}As$(AlGaAs en abrégé), couple non limitatif de l'invention et qui peut être remplacé par d'autres couples de matériaux qui seront décrits ultérieurement.

Décrite à partir de la cathode, la diode selon l'invention comporte:

— Une couche 5 très mince en GaAs de type n$^+$, très dopée. Cette couche 5 a une épaisseur inférieure à 1μ. Elle est nécessaire pour assurer une prise de contact ohmique sur matériau n$^+$ et constitue une source d'électrons vers les autres couches de la diode.

— Une couche 6 mince, d'épaisseur a, en $Al_x$-$Ga_{1-x}As$, non dopée. C'est à travers cette couche non dopée qu'est réalisée l'injection de courant par effet tunnel.

— Une couche 7 en GaAs de type n. C'est cette couche 7 qui constitue la région de transit ou de glissement (drift region) de la diode, et son épaisseur est suffisante pour englober la zone morte.

— Un substrat 9 en GaAs de type n$^+$, lequel a été, avant les opérations de réalisation de la diode, recouvert d'une couche tampon ou buffer 8, de même type de matériau et de conductivité. Le substrat 9 est en matériau monocristallin qui a subi des opérations préalables de sciage et de polissage: il en résulte des imperfections, à sa surface, dans le réseau cristallographique. La fonction de la couche tampon 8, qui est déposée par épitaxie, est de réparer ces imperfections cristallographiques, qui sont atténuées au fur et à mesure que se déposent de nouvelles couches d'atomes du matériau.

La diode est complétée par deux métallisations qui constituent des contacts ohmiques, la métallisation 10 de contact cathodique et la métallisation 11 de contact anodique. Ces contacts ohmiques sont réalisés, par exemple, par la chaîne Ge-Au-Ni.

Les niveaux de dopage sont de l'ordre de $10^{18}$ atomes·cm$^{-3}$ pour les couches n$^+$, et de l'ordre de 1,5 à 2,$10^{15}$ atomes·cm$^{-3}$ pour la couche n à 10 GHz, bien que pour cette dernière le niveau de dopage atteigne $10^{16}$ à 100 GHz.

C'est parce que la diode selon l'invention est composée uniquement de couches de polarité n qu'elle est dite unipolaire. Une semblable diode de polarité p uniquement n'est pas possible, car les trous ne présentent pas le même phénomène de vallées et de pente négative que les électrons.

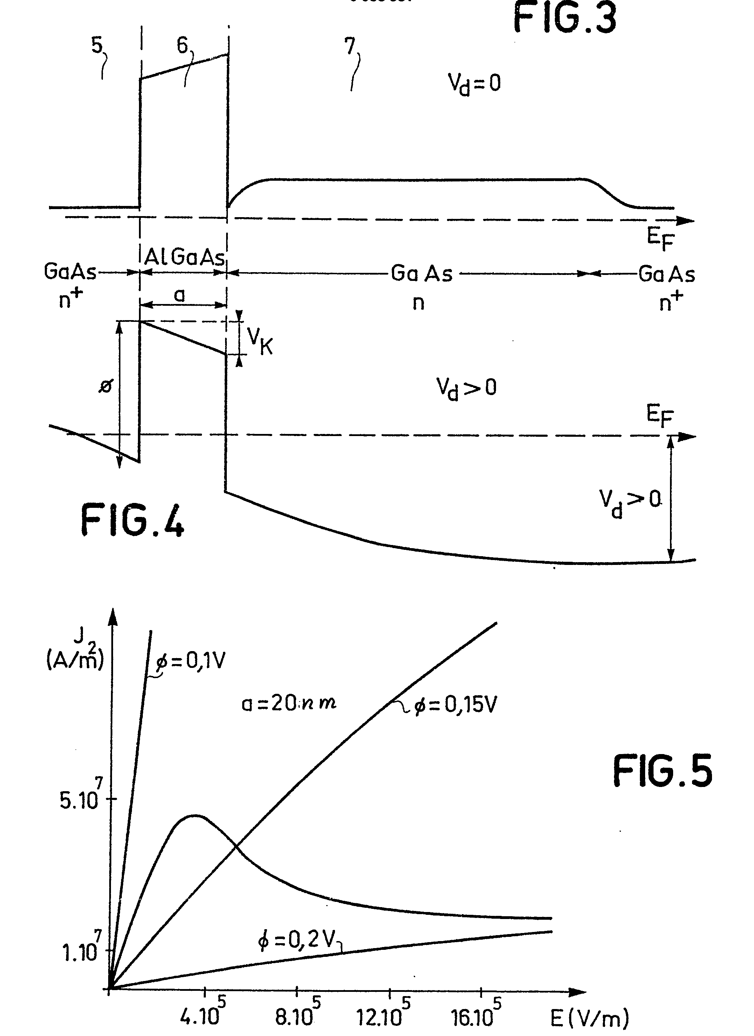

Les fig. 3 et 4 représentent les schémas de bandes de conduction de la structure selon l'invention. L'énergie du bas de la bande de conduction y est représentée en fonction de la distance, c'est-à-dire dans les différentes couches de la diode, pour une tension appliquée $V_d$ nulle sur l'anode en fig. 3 et pour une tension $V_d$ positive en fig. 4. Le niveau d'énergie de Fermi $E_F$ est pris comme niveau de référence.

La fig. 3 donne donc les niveaux d'énergie des différentes couches à l'état statique, hors de toute excitation par un potentiel.

Si l'on applique une tension $V_d > 0$ (fig. 4) sur l'anode de la diode, se traduisant par une tension $V_K > 0$ sur la couche 6 de $Al_xGa_{1-x}As$, les électrons situés dans la région 5 voient une barrière de hauteur $\phi$, ceux de la région 7 une barrière de hauteur $\phi + V_K$; d'où un courant d'électrons de la région 5 vers la région 7 par effet tunnel à travers la couche isolante 6. Les électrons arrivent dans la région de transit 7 avec une énergie $qV_K$, q étant la charge de l'électron.

La caractéristique cathodique, c'est-à-dire le courant tunnel $J(V_K)$, a été déterminée par simulation. Celle-ci montre qu'en jouant sur $\phi$, c'est-à-dire sur la stœchiométrie du composé $Al_xGa_{1-x}As$, et sur l'épaisseur a de la couche, il est possible d'obtenir des conditions d'injection de courant convenables, avec des valeurs de $\phi$ et de a qui soient compatibles avec les possibilités technologiques et en tenant compte de l'effet tunnel assisté par la température ainsi que de l'effet thermo-ionique pur.

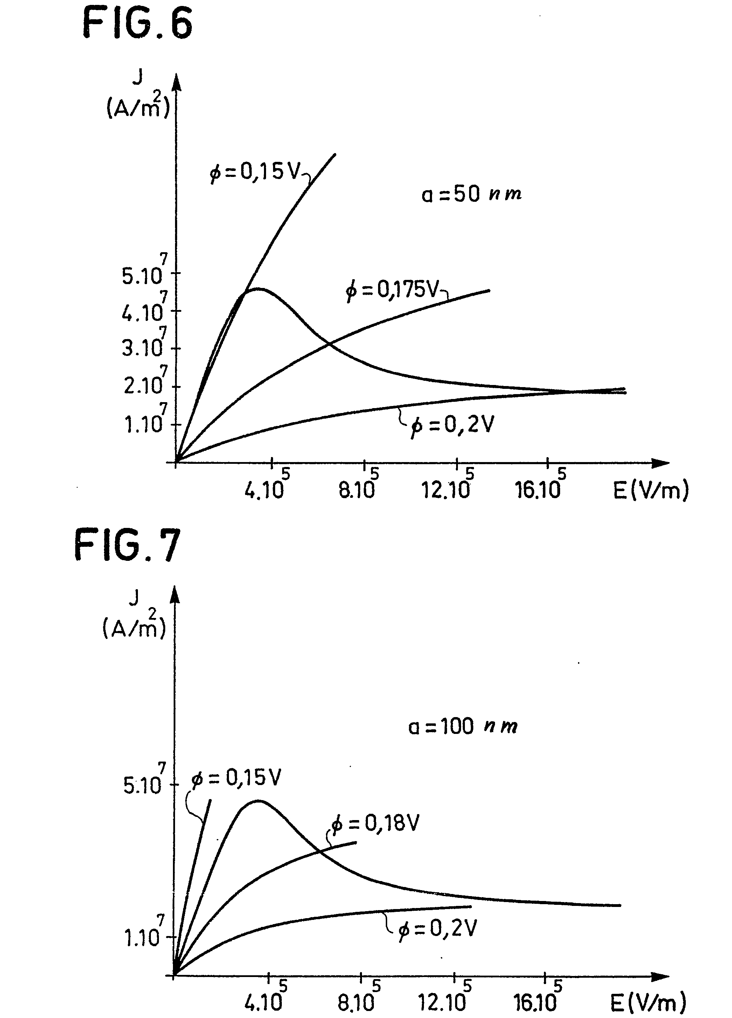

Les fig. 5, 6 et 7 représentent la caractéristique cathodique, c'est-à-dire la densité de courant en fonction du champ E à l'entrée de la région de transit pour différentes épaisseurs a de la couche 6 non dopée de AlGaAs: a=20 nm (200 Å) en fig. 5, 50 nm (500 Å) en fig. 6 et 100 nm (1000 Å) en fig. 7, et pour trois valeurs de la hauteur de barrière $\phi$ (0,15, 0,18 et 0,20 V) choisies de manière à obtenir les trois régimes d'injection. On a représenté sur les mêmes figures la caractéristique neutre qui permet de distinguer les trois régimes d'injection.

Ces courbes permettent de tirer des conclusions pour la réalisation de diodes dotées de caractéristiques cathodiques intéressantes.

D'abord, il est possible d'imposer un régime d'injection approprié — contact limitant/bloquant ou limitant/injectant — avec des valeurs de hauteur de barrière $\phi$ compatibles avec les possibilités technologiques, $\phi$ étant une fonction connue de la valeur de x dans $Al_xGa_{1-x}As$.

Ensuite, l'influence de la hauteur de barrière $\phi$ est très sensible, d'où l'intérêt de l'épitaxie par jets moléculaires permettant un contrôle précis de la stœchiométrie de $Al_xGa_{1-x}As$.

Enfin, l'épaisseur a de la couche 6 non dopée a peu d'influence sur la caractéristique $J(E)$, ce qui veut dire que le champ à la cathode est à peu près identique pour les trois cas. Il n'en est pas de même du potentiel $V_K$ appliqué à la couche, c'est-à-dire de l'énergie $qV_K$ de l'électron émis par la cathode, $V_K$ étant proportionnel à a. Il est donc préférable, pour réduire la zone morte, de choisir a grand, de l'ordre de 100 nm (1000 Å) ou plus. La limite tient d'une part à la valeur maximale acceptable pour $V_K$, qui doit rester faible par rapport à la tension $V_d$ sur la diode, d'autre part au fait que l'influence de $\phi$ sur les caractéristiques d'injection est d'autant plus sensible que a est plus grand.

L'exemple de réalisation de diode Gunn qui a été exposé en s'appuyant sur le couple de matériaux $GaAs/Al_xGa_{1-x}As$ n'est pas limitatif de l'invention et peut être étendu à d'autres couples de matériaux semi-conducteurs, tels que:

| Couches dopées | Couche non dopée |
|---|---|
| (5, 7, 8, 9) | (6) |
| GaAs | $Ga_xIn_{-x}As_yP_{1-y}$ |
| InP | $Al_xIn_{1-x}As$ |
| InP | $Ga_xAl_{1-x}As_ySb_{1-y}$ |
| $Ga_xIn_{1-x}As$ | $(Al_yGa_{1-y})_xIn_{1-x}As$ |

Les compositions de ces matériaux sont choisies de telle façon que le paramètre cristallin de chaque couple de matériaux soit égal et que la discontinuité dans leurs bandes de conduction définisse une hauteur de barrière $\phi$, comme il a été indiqué.

## Revendications

1. Dispositif unipolaire à transfert d'électrons, du type diode Gunn, fonctionnant dans le domaine des hyperfréquences, dont le corps semiconducteur comprend une couche de contact (5) porteuse d'une première métallisation (10) de prise de contact, cette couche (5) étant constituée en un premier matériau très dopé de polarité n+, et une couche de transit (7) constituée du même matériau moins dopé de polarité n, ces deux couches (5 et 7) étant supportées par une couche tampon (8) et par un substrat (9) du même matériau et de même dopage que la couche de contact (5), le substrat (9) constituant le contact anodique du dispositif et supportant une seconde métallisation (11) de prise de contact, l'injection des électrons depuis la couche de contact (5) vers la couche de transit (7) étant réalisée par effet tunnel à travers une double hétérojonction constituée par une couche (6) d'un second matériau, non dopé, présentant une barrière tunnel dans la bande de conduction, cette couche non dopée (6) étant intercalée entre la couche de contact (5) et la couche de transit (7).

2. Dispositif selon la revendication 1, caractérisé en ce que le régime d'injection des électrons à travers la double hétérojonction (5/6, 6/7) est déterminé par la composition du second matériau non dopé, cette composition fixant la hauteur de barrière ($\phi$) de la couche non dopée (6).

3. Dispositif selon l'une des revendications 1 ou 2, caractérisé en ce que, les couches de contact (5), de transit (7), tampon (8) et le substrat (9) étant en GaAs, la couche non dopée (6) formant la double hétérojonction est choisie parmi $Al_xGa_{1-x}As$ et $Ga_xIn_{1-x}As_yP_{1-y}$.

4. Dispositif selon l'une des revendications 1 ou 2, caractérisé en ce que, les couches de contact (5), de transit (7), tampon (8) et le substrat (9) étant en InP, la couche non dopée (6) formant la double hétérojonction est choisie parmi $Al_xIn_{1-x}As$ et $Ga_xAl_{1-x}As_ySb_{1-y}$.

5. Dispositif selon l'une des revendications 1 ou 2, caractérisé en ce que, les couches de contact (5), de transit (7), tampon (8) et le substrat (9) étant en $Ga_xIn_{1-x}As$, la couche non dopée (6) formant la double hétérojonction est en $(Al_yGa_{1-y})_xIn_{1-x}As$.

6. Dispositif selon la revendication 1, caractérisé en ce que l'épaisseur (a) de la couche non dopée (6) formant double hétérojonction est de l'ordre de 100 nm.

## Patentansprüche

1. Unipolare Elektronentransfervorrichtung vom Typ Gunn-Diode, die im Bereich der Mikrowellen arbeitet, deren Halbleiterkörper eine Kontaktschicht (5), die eine erste Kontaktmetallisierung (10) trägt und aus einem ersten, stark dotierten Material der Polarität n+ besteht, und eine transitschicht (7), aufweist, die aus dem gleichen Material besteht, aber schwächer mit der Polarität n dotiert ist, wobei diese beiden Schichten (5 und 7) von einer Pufferschicht (8) und einem Substrat (9) getragen werden, die aus dem gleichen Material bestehen und die gleiche Dotierung wie die Kontaktschicht (5) aufweisen, wobei das Substrat (9) den anodischen Kontakt der Vorrichtung bildet und eine zweite Kontaktmetallisierung (11) trägt, wobei die Elektroneninjizierung von der Kontaktschicht (5) zur Transitschicht (7) durch Tunneleffekt durch eine doppelte Heterojunktion, bestehend aus einer Schicht (6) eines zweiten, nicht dotierten Materials, das eine Tunnelbarriere im Leitband darstellt, erzielt wird, und wobei diese nicht dotierte Schicht (6) zwischen der Kontaktschicht (5) und der Transitschicht (7) eingefügt ist.

2. Vorrichtung nach Anspruch 1, dadurch gekennzeichnet, dass die Injektionsgeschwindigkeit der Elektronen durch die doppelte Heterojunktion (5/6, 6/7) durch die Zusammensetzung des zweiten nicht dotierten Materials bestimmt wird, wobei diese Zusammensetzung die Höhe der Barriere ($\phi$) der nicht dotierten Schicht (6) festlegt.

3. Vorrichtung nach einem der Ansprüche 1 oder 2, dadurch gekennzeichnet, dass die Kontakt- (5), Transit- (7), Puffer- (8) und Substratschichten (9) aus GaAs sind und die nicht dotierte Schicht (6), die die doppelte Heterojunktion bildet, aus $Al_xGa_{1-x}As$ oder $Ga_xIn_{1-x}As_yP_{1-y}$ ausgewählt wird.

4. Vorrichtung nach einem der Ansprüche 1 oder 2, dadurch gekennzeichnet, dass die Kontakt- (5), Transit- (7), Puffer- (8) und Substratschichten (9) aus InP sind und die nicht dotierte Schicht (6), die die doppelte Heterojunktion bildet, aus

ten (9) aus $Ga_xIn_{1-x}As$ sind und die nicht dotierte Schicht (6), die die doppelte Heterojunktion bildet, aus $(Al_yGa_{1-y})_xIn_{1-x}As$ besteht.

6. Vorrichtung nach Anspruch 1, dadurch gekennzeichnet, dass die Dicke (a) der nicht dotierten Schicht (6), die die doppelte Heterojunktion bildet, etwa 100 nm beträgt.

## Claims

1. A unipolar electron transfer device of the Gunn diode type, working in the microwave range, of which the semiconductor body comprises a contact layer (5) carrying a first contact-forming metallisation (10), this layer (5) being formed by a first highly doped material of n+ polarity, and a transit layer (7) formed from the same but less doped material of n polarity, these two layers (5 and 7) being supported by a buffer layer (8) and by a substrate (9) of the same material and same doping rate as the contact layer (5), the substrate (9) forming the anode contact of the device and carrying a second contact-forming metallisation (11), the injection of electrons from the contact layer (5) towards the transit layer (7) being performed by tunnel effect through a double heterojunction formed by a layer (6) of a second and undoped material having a tunnel barrier in the conduction band, this undoped layer (6) being interposed between said contact layer (5) and the said transit layer (7).

2. A device according to Claim 1, characterised in that the mode of injection of the electrons through the double heterojunction (5/6, 6/7) is determined by the composition of the second undoped material, this composition determining the barrier height ($\phi$) of the undoped layer (6).

3. A device according to one of Claims 1 or 2, characterised in that the contact layer (5), the transit layer (7), buffer layer (8) and substrate layer (9) are made of GaAs, and the undoped layer (6) forming the double heterojunction is selected from $Al_xGa_{1-x}As$ and $Ga_xIn_{1-x}As_yP_{1-y}$.

4. A device according to one of Claims 1 or 2, characterised in that the contact layer (5), transit layer (7), buffer layer (8) and the substrate layer (8) are of InP, and the undoped layer (6) forming the double heterojunction is selected from $Al_xIn_{1-x}As$ and $Ga_xAl_{1-x}As_ySb_{1-y}$.

5. A device according to one of Claims 1 or 2, characterised in that the contact layer (5), the transit layer (7), the buffer layer (8) and the substrate layer (9) are of $Ga_xIn_{1-x}As$, and the undoped layer (6) forming the double heterojunction consists of $(Al_yGa_{1-y})_xIn_{1-x}As$.

6. A device according to Claim 1, characterised in that the thickness (a) of the undoped layer (6) forming the double heterojunction is of the order of 100 nm.
$Al_xIn_{1-x}As$ oder $Ga_xAl_{1-x}As_ySb_{1-y}$ ausgewählt wird.

5. Vorrichtung nach einem der Ansprüche 1 oder 2, dadurch gekennzeichnet, dass die Kontakt- (5), Transit- (7), Puffer- (8) und Substratschich-

# FIG.1

# FIG.2

0 083 531

FIG.3

$V_d = 0$

$E_F$

GaAs
$n^+$   AlGaAs   GaAs
n   GaAs
$n^+$

$a$

$\emptyset$   $V_K$

$V_d > 0$

$E_F$

$V_d > 0$

FIG.4

FIG.5

$J_2$
$(A/m^2)$   $\emptyset = 0,1V$

$a = 20\,nm$   $\emptyset = 0,15V$

$5.10^7$

$\emptyset = 0,2V$

$1.10^7$

$4.10^5$   $8.10^5$   $12.10^5$   $16.10^5$   $E(V/m)$

# FIG.6

$J$
$(A/m^2)$

$\phi = 0{,}15\,V$

$a = 50\,nm$

$5.10^7$
$4.10^7$
$3.10^7$
$2.10^7$
$1.10^7$

$\phi = 0{,}175V$

$\phi = 0{,}2V$

$4.10^5$  $8.10^5$  $12.10^5$  $16.10^5$  $E(V/m)$

# FIG.7

$J$
$(A/m^2)$

$a = 100\,nm$

$5.10^7$

$\phi = 0{,}15\,V$

$\phi = 0{,}18\,V$

$1.10^7$

$\phi = 0{,}2\,V$

$4.10^5$  $8.10^5$  $12.10^5$  $16.10^5$  $E(V/m)$

11